# EUROPÄISCHE PATENTANMELDUNG

(11) **EP 1 637 919 A1**
(43) Veröffentlichungstag der Anmeldung: **22.03.2006**
(21) Anmeldenummer: 05018440.7
(22) Anmeldetag: 25.08.2005
(51) Int. Cl.: G02B 27/09, H01S 3/23

(54) **Verfahren und Vorrichtung zur Überlagerung von Strahlenbündeln**

(30) Priorität: 20.09.2004 DE 102004045914
(71) Anmelder: My Optical Systems GmbH, 97232 Giebelstadt (DE)
(72) Erfinder: Jurca, Marius christian, 63755 Alzenau (DE)
(74) Vertreter: Ostertag, Ulrich

(57) **Zusammenfassung**

Es werden ein Verfahren und eine Vorrichtung beschrieben, mit denen Strahlenbündel, die von einer Vielzahl von Einzelstrahlungsquellen (201) ausgehen, mit Hilfe einer Strahlformungs- und Fokussieroptik zusammengeführt werden. Die Einzelstrahlungsquellen (201) liegen auf mindestens einer die optische Achse (202) der Strahlformungs- und Fokussieroptik umgebenden Kurve. Sie sind dabei so plaziert, daß ihre Anordnung zu keiner die optische Achse (202) enthaltenden Ebene spiegelsymmetrisch ist. Hierdurch wird vermieden, daß am Werkstück rückreflektierte Strahlung eine Einzelstrahlungsquelle (201) beschädigen kann.

## Beschreibung

Die Erfindung betrifft ein Verfahren zur Überlagerung von Strahlenbündeln, die von einer Vielzahl von Einzelstrahlungsquellen ausgehen und mit Hilfe einer Strahlformungs- und Fokussieroptik zusammengeführt werden, wobei die einzelnen Strahlungsquellen auf mindestens einer die optische Achse der Strahlformungs- und Fokussieroptik umgebenden Kurve angeordnet sind,
sowie eine

Vorrichtung zur Überlagerung von Strahlenbündeln, die von einer Vielzahl von Einzelstrahlungsquellen ausgehen, mit einer Strahlformungs- und Fokussieroptik, welche die Strahlenbündel zu einem Überlagerungspunkt zusammenführt, wobei die Einzelstrahlungsquellen auf mindestens einer die optische Achse der Strahlformungs- und Fokussieroptik umgebenden Kurve angeordnet sind.

Derartige Verfahren und Vorrichtungen finden ihren Einsatz dort, wo die Strahlung mehrerer Einzelstrahlungsquellen, z.B. zur Leistungssteigerung, in einem relativ kleinen räumlichen Arbeitsbereich konzentriert werden soll. Derartige Anwendung liegen in der Materialbearbeitung, z. B. beim Laserschweißen, -schneiden oder -bohren sowie bei der Oberflächenbehandlung. Ebenso gibt es medizinische Behandlungen in der Ophthalmologie, in der Zahntechnik und in der Dermatologie. Ein weiteres Einsatzgebiet liegt im Bereich der Telekommunikation, wenn in einem durch eine optische Faser realisierten Datenübertragungskanal eine hohe Lichtleistung zur Informationsübertragung über weite Strecken ohne zwischengeschalteten Verstärker benötigt wird. Dort ist eine kleine numerische Apertur der einkoppelnden Optik erforderlich.

Bei bekannten derartigen Verfahren und Vorrichtungen werden üblicherweise Laserdioden-Arrays als Lichtquellen eingesetzt, die als "Barren" oder "Stacks" bezeichnet werden. Ein "Barren" weist eine Vielzahl von in eine lineare Reihe eingeordneten einzelnen Laserdioden auf. Ein Hochleistungs-Laserdioden-Array dieser Art hat eine typische Ausgangslichtleistung von etwa 50 W. Typische Gesamtemissionsflächen derartiger Laserdioden-Arrays haben eine Längsseite (lange Achse, "Slow-Axis" genannt) von etwa 10 mm und eine Schmalseite (kurze Achse, "Fast-Axis" genannt) von ca. einem Mikrometer. Die einzelnen Laserdiodenstrukturen sind dabei linear auf der Längsseite des Barrens verteilt (etwa 10 bis 50 Stück) und weisen üblicherweise entlang der Längsseite des Barren eine Breite von 40 Mikrometer bis 500 Mikrometer auf. Die Strahldivergenz des von den Laserdioden-Arrays emittierten Lichtes in den Ebenen parallel zur kurzen Achse der Emissionsfläche ist typischerweise um einen Faktor 3 bis 4 größer als in den dazu senkrechten Richtungen und entspricht damit der Abstrahlcharakteristik der einzelnen Laserdiodenstrukturen, welche "Emitter" oder "Einzelemitter" genannt werden. Die Strahlung der Einzelemitter ist nicht kohärent mit der Strahlung der benachbarten Strukturen. Zwischen den Emittern wird kein Licht emittiert.

Derartige "Barren" können aufeinandergestapelt werden, wodurch sich "Stacks" ergeben. Die Emissionsbündel der einzelnen Emissionsflächen der Laserdioden-Arrays innerhalb des "Stacks" werden überlagert, um die Lichtleistung des gesamten "Stacks" zu nutzen. Hierzu ist es bekannt, jedem Einzelemitter innerhalb der im "Stack" gestapelten Laserdioden-Arrays eine Mikrolinse zuzuordnen, die das Emissionsbündel eines Einzelemitters auf das Einkoppelende einer diesem zugeordeten optischen Faser führt. Auf diese Weise ist einem "Barren" oder auch einem "Stack" eine Vielzahl von Fasern zugeordnet, die in einem Faserbündel geführt werden können. Das Auskoppelende des Faserbündels kann dann zur Erzeugung eines Arbeits-Laserstrahlenbündels abgebildet werden. Mit dieser Anordnung sind drei Nachteile verbunden: Zum einen geht Licht verloren, weil die Optik nicht vollständig ausgeleuchtet werden kann. Zum anderen muß, um einen kleinen Brennpunkt zu erhalten, die Brennweite der Mikrolinsen klein gehalten werden, was zu einer mit Einkoppelverlusten verbundenen großen numerischen Apertur führt. Schließlich ist die Anzahl der auf diese Art in einem gemeinsamen Fokuspunkt aufaddierbaren Einzellichtquellen begrenzt.

Die Handhabung eines derartigen Mikrolinsen-Arrays ist relativ kompliziert, da die Mikrolinsen nahe an den Einzelemittern angeordnet werden müssen und die Justage entsprechend kritisch ist. Zusätzlich ist bei Einsatz von Mikrolinsen in Verbindung mit Hochleistungs-Laserdioden-Arrays die Herstellung und Materialauswahl sehr problematisch, da kleinste Absorptionen bei der Emissionswellenlänge der Laserdioden zu einer nicht hinnehmbaren Aufheizung der Mikrolinsen führen.

Strahlführungssysteme, die das Licht mehrerer räumlich verteilter punktförmiger Lichtquellen in einem Fokuspunkt konzentrieren, sind bekannt. In wellenoptischen Begriffen ausgedrückt unterscheidet man dabei Verfahren, in denen die Wellenfronten der Einzellichtquellen zur Überlappung gebracht werden, und solche Verfahren, in denen die Wellenfronten der Einzellichtquellen nebeneinandergesetzt werden, um in der Kombination eine größere Gesamtwellenfront zu bilden. Dabei wird vorausgesetzt, daß das Strahlenbündel jeder Einzellichtquelle und damit auch die Wellenfront, definiert als Eikonalfläche des Strahlenbündels, einen ähnlichen Querschnitt aufweist.

Beim Einsatz des eingangs genannten Verfahrens bzw. der eingangs genannten Vorrichtung für das Lasermarkieren ist eine der wichtigsten Voraussetzungen, daß eine bestimmte materialabhängige Schwelle der Leistungsdichte am Werkstück durch die aufgebrachte Laserstrahlung überschritten wird. Die meisten Oberflächen, die markiert werden sollen, insbesondere die Metalle, reflektieren die Laserstrahlung stark. Erst nach Überschreiten der Leistungsdichteschwelle bildet sich in der Oberfläche eine Kapillare (sogenanntes "Key-Hole"), wodurch schlagartig der größte Teil der aufgebrachten Laserstrahlung absorbiert wird. Die von der Objektoberfläche zurückgestrahlte Laserstrahlung stellt ein schwerwiegendes Problem dar, da diese die Fokussieroptik rückwärts passiert, so daß die optischen Komponenten, die zur Fokussierung verwendet werden, der doppelten oder punktuell noch größeren optischen Belastungen ausgesetzt werden. Dabei können nicht nur Beschichtungen und Gläser sondern auch Fasern und Kristalle in den entsprechenden Konfigurationen zerstört werden. Noch stärker gefährdet sind die als Einzellichtquellen eingesetzten Laserdioden, insbesondere Hochleistungs-Laserdioden. Es ist bekannt, daß Laserdiodensysteme sehr empfindlich im Falle von Rückreflexen reagieren und dabei zerstört werden können.

Zum Markieren benötigt man keine besonders hohen Leistungen, üblicherweise zwischen 10 und 100 Watt. Dementsprechend kommt es auf die Größe und Form des Brennflecks auf der Werkstückoberfläche an. Bedingt durch die starke Anisotropie der Strahlung, die, wie oben ausgeführt, Hochleistungslaserdioden üblicherweise aufweisen, und die fehlende Kohärenz der Strahlung in der "Slow-Axis" ist es mit normalen optischen Fokussierungselementen nicht möglich, für praxistaugliche Arbeitsabstände einen Fokus zu erzeugen, der so klein ist, daß die obengenannte Leistungsdichteschwelle zum Markieren auf metallischen Oberflächen überschritten wird. Insgesamt sind daher Hochleistungslaserdioden-Arrays auf Grund ihrer Strahlqualität für eine derartige Aufgabe prima facie denkbar ungeeignet. Es ist zwar so, daß die Markierung an der Oberfläche der Werkstücke erfolgt, d.h., anders als im Falle des Schweissens bzw. Tiefschweissens wird eine große Tiefenschärfe für die Laserfokussierung nicht benötigt. Bei einer entsprechend kleinen Brennweite und großen Apertur der Fokussieroptik kann somit ein ausreichend kleiner Fokus erzeugt werden. Ein solcher kleiner Fokus nutzt in der Praxis jedoch meistens nichts, da insbesondere für Markierungszwecke ein schlankes Strahlenbündel, d.h. eine kleine Divergenz der Strahlen im Fokus benötigt wird, um das Strahlenbündel über einen Scanner, meistens XY-Scanner, umlenken zu können, der üblicherweise eine kleine freie Strahlapertur aufweist.

Die meisten bekannten Vorrichtungen zum Lasermarkieren benutzen lampengepumpte Festkörperlaser. Diese haben einen vergleichsweise schlechten Wirkungsgrad. Bei den blitzlampengepumpten Festkörperlasern stammt die Pumpenenergie aus dem Emissionsspektrum der Blitzlampen. Der Gesamtwirkungsgrad solcher Vorrichtungen liegt bei ca. 3%. Die Verwendung von Laserdioden zum Pumpen von Festkörperlasern erhöht den Wirkungsgrad der so gepumpten Festkörperlaser erheblich (ca. 50% für die Hochleistungslaserdioden, ca. 50% für die optische Einkopplung der Energie und schließlich weitere ca. 50% Wirkungsgrad des Festkörpers selbst, was einem Gesamtwirkungsgrad von bestenfalls 12,5% entspricht). Es ist daher leicht nachvollziehbar, warum die unmittelbare Verwendung von Laserdioden mit einem Wirkungsgrad von etwa 50% wirtschaftlich so reizvoll ist.

Bekannte Fokussiervorrichtungen, die ausschließlich Laserdioden verwenden, sind oft nicht sehr effektiv, obwohl die Effizienz der Laserdioden sehr hoch ist. So sind Vorrichtungen bekannt, in denen ein Strahlenbündel an einem teilweise lichtdurchlässigen Umlenkspiegel so umgelenkt wird, daß es parallel und überlappend zu einem zweiten Strahlenbündel verläuft. Eine verlustfreie Einkopplung ist möglich, wenn der Umlenkspiegel eine wellenlängenabhängige Reflektivität aufweist und die beiden Strahlenbündel verschiedene Wellenlängen haben. In analoger Weise kann ein polarisierender Strahlteilerwürfel zwei Strahlenbündel mit orthogonaler Polarisation vereinen. Nachteilig ist, daß nur zwei Strahlenbündel vereint werden können.

Bekannt ist auch die Vereinigung mehrerer Strahlenbündel verschiedener Wellenlänge mit Hilfe eines Beugungsgitters. Nachteilig ist, daß die Einkopplungseffizienz des Beugungsgitters weit unter 100% liegt und monochromatische Lichtquellen mit einer genau abgestuften Sequenz von Wellenlängen benötigt werden.

Bei bekannten Vorrichtungen der eingangs genannten Art wird einer zeilig angeordneten Gruppe von Lichtquellen der Laserdiodenstruktur oder einer einzelnen Lichtquelle jeweils ein optisches Bauelement (Linse, Spiegel, Prisma) zugeordnet, das die Aufgabe hat, das Licht dieser Gruppe von Lichtquellen so abzulenken oder zu formen, daß die Fokuspunkte der Strahlenbündel, die von allen Einzellichtquellen der Laserdiodenstruktur stammen, in einem Punkt aufeinandertreffen.

Ein Beispiel für eine derartige Vorrichtung ist in der WO 99/64912 A1 beschrieben. Dabei wird eine zweidimensionale Matrix von Mikrolinsen verwendet, von denen jede das Strahlenbündel einer Einzellichtquelle kollimiert. Nach der Mikrolinsen-Matrix laufen die Strahlen aller Einzellichtquellen parallel, so daß eine fokussierende Linse die Strahlenbündel in einem einzigen Brennfleck sammeln kann. Bei einer Variante dieses bekannten Prinzips wird die Mikrolinsen-Matrix durch zwei nacheinander angeordnete, zeilenartige Systeme von Zylinderlinsen ersetzt. Die Zylinderachsen des ersten Systems stehen senkrecht zu den Zylinderachsen des zweiten Systems. Jeder Zylinderlinse ist eine Zeile bzw. Spalte von Lichtquellen zugeordnet. Die Zylinderlinsen des ersten Systems richten alle Strahlen parallel zu einer Ebene, die Zylinderlinsen des zweiten Systems richten die Strahlen parallel zueinander aus.

Die in der DE 195 37 265 C1 beschriebene Vorrichtung verwendet eine Matrix von Mikroprismen, die die Strahlenbündel einer Matrix von Einzellichtquellen einer Laserdiodenstruktur so ablenken, daß alle Strahlenbündel scheinbar denselben Ausgangspunkt haben. Ein dahinter angeordnetes optisches System bildet den gemeinsamen virtuellen Objektpunkt auf den Brennfleck in der Fokusebene ab.

Bei einer weiteren Gruppe von bekannten Vorrichtungen, wie sie beispielsweise in der DE 195 14 626 A und DE 197 25 262 A beschrieben sind, werden Paare von Treppenspiegeln oder Treppenprismen verwendet, welche die einzelnen Strahlenbündel eines Systems von parallel laufenden, aber weit auseinanderliegenden Strahlenbündeln derart versetzen, daß der Abstand zwischen benachbarten Strahlenbündeln verringert oder auf Null gebracht wird.

Nachteilig an all diesen bekannten Vorrichtungen ist, wie bereits oben angedeutet, daß ein Diodenbarren 12 bis 48 zeilig angeordnete Einzelemitter enthält und für jeden Einzelemitter ein optisches Ablenkelement der beschriebenen Art hergestellt werden muß. Bei Vorrichtungen ohne Justagemöglichkeit sind bei der Herstellung Positionstoleranzen der Ablenkelemente im Mikrometerbereich einzuhalten, damit die Strahlenbündel hinreichend genau parallelisiert werden. Bei Vorrichtungen mit Justagemöglichkeit ist jedes dieser 12 bis 48 Ablenkelenente mikrometergenau zu positionierren. Darüber hinaus muß die dauerhafte Stabilität der eingestellten Positionen sichergestellt werden.

Weitere Verfahren zur Kombination der Wellenfronten von Einzellichtquellen sind in der DE 100 62 453 A, DE 100 62 454 A und DE 199 49 198 A beschrieben. Hier kommen Ringanordnungen von Diodenbarren zum Einsatz, die eine homogene Ausleuchtung des Brennpunktes sicherstellen. Durch die Verwendung von Dioden-Arrays leidet die Strahlqualität; durch die zwar technologisch vorteilhaft freie optische Achse des Fokussierkopfes wird die Strahlqualität durch Reduktion des "Füllfaktors" beeinträchtigt. Dadurch, daß die Strahlformungskomponenten um die mittlere freie optische Achse herum angeordnet sind, ergibt sich eine größere Divergenz des Strahlenbündels im Fokus als bei Nutzung des mittleren Raumes.

In der US 6 137 631 A wird das Licht eines Laserdiodenbarrens mit Hilfe einer Zylinderlinse und einer nachfolgenden sphärischen Optik kollimiert. Im Kreuzungspunkt der Strahlenbündel der Einzelemitter befindet sich die Öffnung, durch die das Licht in ein Reflektorelement eintritt, das aus einem Paar von parallelen Spiegeln besteht. Die Strahlenbündel werden je nach Einfallswinkel verschieden oft reflektiert. Auf der Austrittsöffnung des Reflektorelements befindet sich eine fokussierende Linse, die ein Zwischenbild des Barrens erzeugt. Die Anordnung ist ähnlich wie in der DE 101 21 678 A. Diese bringt zwar alle Bilder der Einzelemitter eines Barrens sehr effizient zur Deckung; der Brennfleck ist jedoch nur die vergrößerte Abbildung eines Einzelemitters und die Anordnung ist aus praktischen Gründen auf einen Diodenbarren beschränkt. Die Strahlqualität ist allerdings durch die Erhöhung des sogenannten "Füllgrades" verbessert, da die einzelnen Strahlenbündel aus unterschiedlichen Richtungen in den Fokuspunkt gelangen.

Aus der US 48 26 269 A schließlich ist ebenfalls eine kreisförmige Laserdioden-Anordnung bekannt, bei der zur Fokussierung der Laserdioden eine in mehrfacher Hinsicht nachteilige anamorphotische Abbildung verwendet wird.

Aufgabe der vorliegenden Erfindung ist es, ein Verfahren und eine Vorrichtung der eingangs genannten Art so auszugestalten, daß die Gefahr der Beschädigung von Einzelstrahlungsquellen durch am Werkstück rückreflektierte Strahlung reduziert ist.

Diese Aufgabe wird, was das Verfahren angeht, dadurch gelöst, daß die Einzelstrahlungsquellen so um die optische Achse der Strahlformungs- und Fokussieroptik herum angeordnet werden, daß die Anordnung zu keiner die optischen Achse enthaltenden Ebene spiegelsymmetrisch ist. Bei der erfindungsgemäßen Plazierung der Einzelstrahlungsquellen ist aufgrund der gewählten Symmetrieeigenschaften ausgeschlossen, daß rückreflektierte Strahlung auf eine Einzelstrahlungsquelle gerichtet wird. Vielmehr werden derartige Rückreflexe an Einzelstrahlungsquellen vorbeigeleitet.

Besonders zweckmäßig ist diejenige Variante des erfindungsgemäßen Verfahrens, bei welcher die Anordnung eine in Bezug auf die optische Achse der Strahlformungs- und Fokussieroptik nzählige Symmetrie aufweist, wobei n eine ungerade, ganze Zahl größer als 1 ist.

Die obige Aufgabe wird, was die Vorrichtung angeht, dadurch gelöst, daß die Einzelstrahlungsquellen so um die optische Achse der Strahlformungs- und Fokussieroptik herum angeordnet sind, daß die Anordnung zu keiner die optische Achse enthaltenden Ebene spiegelsymmetrisch ist. Die Vorteile der erfindungsgemäßen Vorrichtung entsprechen den oben geschilderten des erfindungsgemäßen Verfahrens.

Auch die im Anspruch 4 angegebene vorteilhafte Ausführungsform der erfindungsgemäßen Vorrichtung hat ein Analogen in einer oben schon beschriebenen Verfahrensvariante.

Ausführungsbeispiele der Erfindung werden nachfolgend anhand der Zeichnung näher erläutert; es zeigen
- Figur 1: einen Meridionalschnitt durch ein erstes Ausführungsbeispiel einer Vorrichtung zur Überlagerung von Strahlenbündeln;
- Figur 2: einen Schnitt gemäß Linie II-II von Figur 1;
- Figur 3: schematisch den auf eine Sagittalebene projizierten Strahlengang in einem zweiten Ausführungsbeispiel einer Vorrichtung zur Überlagerung von Strahlenbündeln;
- Figur 4: im Meridionalschnitt die Vorrichtung der Figur 3;
- Figur 5: eine Ansicht ähnlich der Figur 3, bei der jedoch eine nicht spiegelsymmetrische Anordnung der Einzellichtquellen gewählt ist;
- Figur 6: in isometrischer Darstellung eine Wärmeschutzeinrichtung, die bei allen Ausführungsbeispielen der Erfindung eingesetzt werden kann.

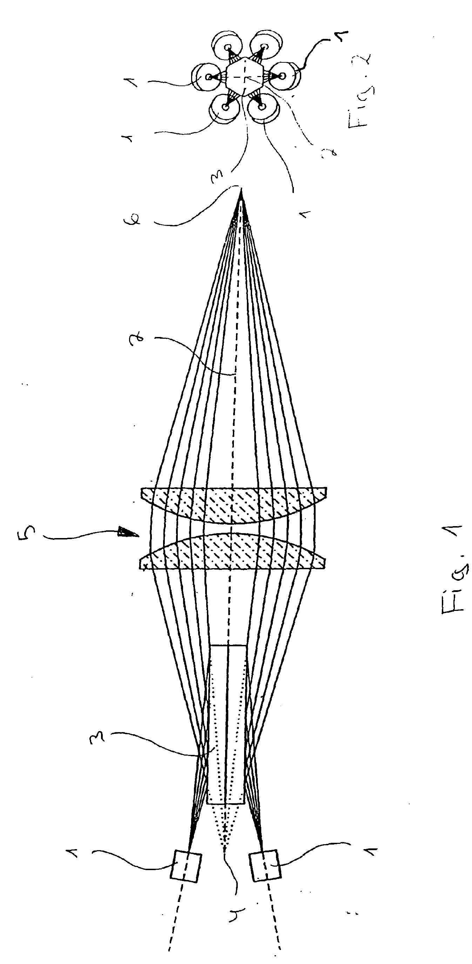

Zunächst wird auf die Figuren 1 und 2 Bezug genommen. Die hier dargestellte Vorrichtung kann insbesondere zu Markierungszwecken an Werkstücken eingesetzt werden. Sie umfaßt sechs Einzelemitter, im vorliegenden Falle Einzel-Laserdioden 1, die in gleichem Winkelabstand von jeweils 60° zueinander auf einem Kreis um die optische Achse 2 der Vorrichtung angeordnet sind. Jeder Einzelemitter 1 gibt im wesentlichen linear polarisiertes, räumlich möglichst kohärentes Licht ab. Je besser die Kohärenz, umso besser ist die Strahlqualität im Fokus.

Die Anzahl der verwendeten Einzelemitter 1 ist grundsätzlich gleichgültig, solange deren Abstand voneinander so groß ist, daß jedes von einem Einzelemitter 1 ausgehendes Strahlenbündel getrennt von den anderen Strahlenbündeln abgebildet werden kann.

Die Einzelemitter 1 strahlen Licht auf einen im Querschnitt sechseckigen Polygonspiegel 3 ab, dessen Achse mit der optischen Achse 2 zusammenfällt. Der Polygonspiegel 3 besteht vorzugsweise aus Metall. Die einzelnen, rechteckigen Spiegelflächen des Polygonspiegels 3 sind dabei den Einzellichtquellen 1 so zugeordnet, daß die in Figur 2 dargestellte Anordnung entsteht. Die Einzelspiegelflächen werden unter einem so flachen Winkel angestrahlt, daß eine Totalreflexion eintritt. Der Einfallswinkel, gemessen gegen das Lot auf die reflektierende Fläche, ist hierzu größer als 45°.

Bei der geschilderten geometrischen Anordnung von Polygonspiegel 3 und Einzellichtquellen 1 werden die einzelnen Lichtbündel vom Polygonspiegel 3 so reflektiert, als kämen sie von einem gemeinsamen Ausgangspunkt 4. Eine Strahlformungs- und Fokussieroptik 5, die im dargetellten Ausführungsbeispiel durch zwei plankonvexe Linsen realisiert ist, bildet die vom Polygonspiegel 3 ausgehenden, divergierenden Strahlen in der Brennebene, in welcher sich das Werkstück befindet, in einem Fokuspunkt 6 ab.

Die Einzelemitter 1 sind auf dem erwähnten Kreis so angeordnet, daß ihre "Fast-Axis" in azimutaler Richtung, also tangential zu dem Kreis verläuft. Die Einzelemitter 1 senden so ihr von Hause aus linear polarisiertes Licht so auf die Reflexionsflächen des Polygonspiegels 3 aus, daß dieses Licht praktisch verlustfrei reflektiert wird. Wird das im Fokuspunkt 6 gesammelte Licht am Werkstück reflektiert, so entsteht typischerweise eine elliptische Polarisierung der Strahlung. Wird diese nunmehr rückwärts durch die Fokussieroptik 5 auf den Polygonspiegel 3 gelenkt, wird der "Rückreflex" wegen der ungünstigen Polarisation am Polygonspiegel 3 teilweise oder ganz vernichtet. Die Gefahr einer Beschädigung der Einzelemitter 1 durch rückreflektiertes Licht ist somit stark reduziert.

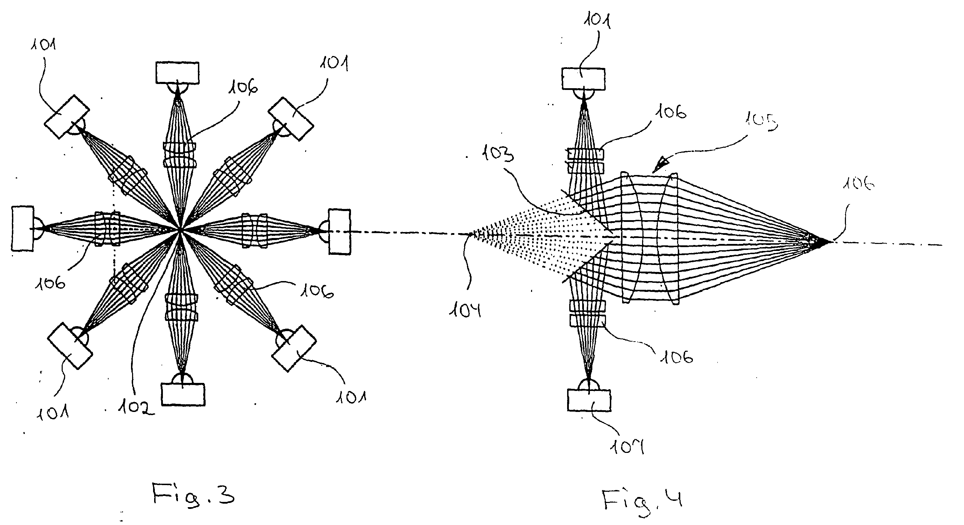

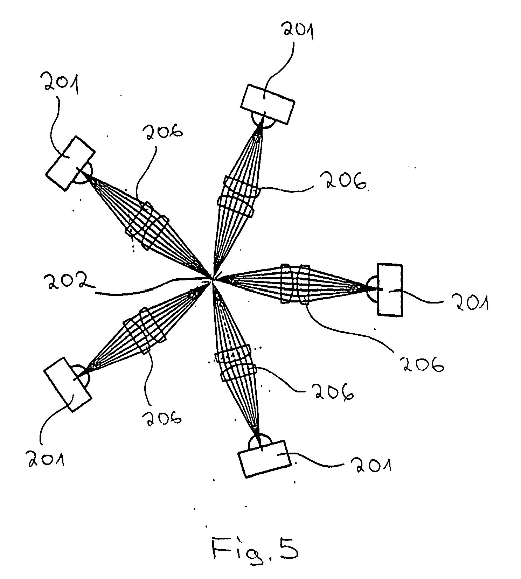

In den Figuren 3 und 4 ist eine Vorrichtung zur Markierung von Werkstücken dargestellt, die der oben anhand der Figuren 1 und 2 dargestellten sehr ähnelt. Entsprechende Teile sind daher mit demselben Bezugszeichen zuzüglich 100 gekennzeichnet.

Auch die Vorrichtung von Figuren 3 und 4 umfaßt eine Vielzahl, im dargestellten Ausführungsbeispiel acht, Einzelemittern 101, die auf einem Kreis um die optische Achse 102 der Vorrichtung angeordnet sind. Anders als beim Ausführungsbeispiel der Figuren 1 und 2 geben die Einzelemitter 101 ihr Licht jedoch im wesentlichen in radialer Richtung ab.

Die Einzelemitter 101 sind so ausgerichtet, daß ihre Slow-Achsen azimutal, also tangential zu dem Kreis verlaufen, auf dem die Einzelemitter 1 angeordnet sind.

Jedes aus einem Einzelemitter 101 austretende divergente Lichtbündel trifft zunächst auf eine Zylinderoptik 106, die im vorliegenden Falle zwei plankonvexe Zylinderlinsen umfaßt. Wie insbesondere der Figur 3 zu entnehmen ist, beeinflussen die Zylinderoptiken 106 die Ausbreitung des Lichtes in Richtung der "Fast-Axis" nicht, während durch die Zylinderoptiken 106 in Richtung der "Slow-Axis" eine Fokussierung auf die optische Achse 2 erfolgt.

Nach dem Durchtritt durch die Zylinderoptiken 106 treffen die von den Einzelemittern 101 ausgehenden Strahlenbündel auf einen Kegelspiegel 103, der ähnlich wie beim Ausführungsbeispiel der Figur 1 und 2 facettiert sein kann, jedoch auch als echter Kreiskegel ausgestaltet sein kann. Die Reflexion der einzelnen Strahlenbündel an dem Kegelspiegel 103 erfolgt wieder so, daß nach der Reflexion alle Strahlen von einem einzigen virtuellen Objektpunkt 104 auszugehen scheinen. Die Abbildung des virtuellen Objektpunktes 104 auf den auf der Werkstückoberfläche liegenden Fokuspunkt 106 erfolgt erneut mit Hilfe einer Strahlformungs- und Fokussieroptik 105.

Die Funktionsweise des in den Figuren 3 und 4 dargestellten Ausführungsbeispieles entspricht grundsätzlich derjenigen des ersten Ausführungsbeispieles, wobei der Kegelspiegel 103 nunmehr die Schutzfunktion gegen rückreflektiertes Licht übernimmt, die auf den unterschiedlichen Polarisationszuständen des von den Einzelemittern 101 zugestrahlten und des vom Werkstück zurückreflektierten Lichtes beruht.

Bei den Ausführungsbeispielen der Figuren 1 bis 4 war die Anordnung der Einzelemitter 1 bzw. 101 bezüglich verschiedener die optische Achse 2 bzw. 102 enthaltender Ebenen spiegelsymmetrisch. Dies hat den Nachteil, daß unter ungünstigen Umständen, insbesondere wenn die Schutzwirkung des Polygonspiegels 3 bzw. des Kegelspiegels 103 nicht ausreicht, Licht, das von einem Einzelemitter 1 bzw. 101 ausgeht, nach der Reflexion am Werkstück auf einen spiegelsymmetrisch liegenden Einzelemitter 1 bzw. 101 treffen kann. Um für diesen Fall vorzubeugen, kann die Anordnung der Einzelemitter auch so vorgenommen werden, daß keine die optische Achse 2 bzw. 102 enthaltende Spiegelebene vorliegt.

Dies ist für ein Ausführungsbeispiel mit fünf Einzelemittern 201 in Figur 5 dargestellt, die grundsätzlich der Figur 3 entspricht. Statt acht Einzelemittern 801 sind hier nur fünf Einzelemitter 201 vorgesehen, die jeweils in gleichem Winkelabstand voneinander, nämlich im Winkelabstand von 72°, angeordnet sind. Die Zeichnung macht deutlich, daß keinem dieser Einzelemitter 201 diametral gegenüber ein weiterer Einzelemitter 201 zugeordnet ist, sodaß Licht, welches von einem dieser Einzelemitter 201 ausgeht, nach der Reflexion am Werkstück nicht auf einen gegenüberliegenden Einzelemitter 201 treffen und diesen beschädigen kann.

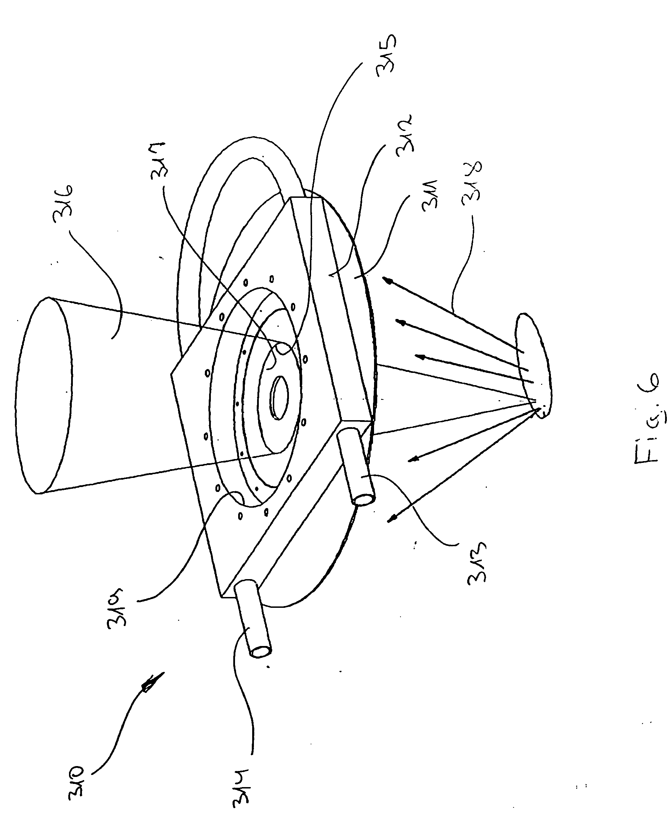

Durch die Überlagerung der verschiedenen von den Einzelemittern 1 bzw. 101 ausgehenden Strahlenbündel entsteht im Brennfleck 6 bzs. 106 eine sehr hohe Energiedichte. Hierdurch wird das Werkstück erwärmt. Die entsprechende (sekundäre) Wärmestrahlung wirkt zurück auf den die Strahlformungs- und Fokussieroptik und die Einzelemitter enthaltenden Arbeitskopf. Um diesen vor der Wärmestrahlung zu schützen, kann eine Schutzeinrichtung vorgesehen werden, wie sie in Figur 6 schematisch dargestellt und insgesamt mit dem Bezugszeichen 310 versehen ist. Diese Wärmeschutzeinrichtung 310 wird jeweils zwischen dem Austrittsfenster der Strahlformungs- und Fokussieroptik 5; 105 und dem Brennfleck 6; 106 angeordnet. Sie umfaßt ein kreisförmiges, als Abschirmung dienendes Kupferblech 311, das an einem hohlen Aluminiumblock 312 befestigt ist. Der Aluminiumblock 312 besitzt zwei Anschlüsse 313 bzw. 314, so daß er von Kühlwasser durchströmt werden kann. Er wird seinerseits an dem in Figur 6 nicht dargestellten Arbeitskopf befestigt.

Das Kupferblech 311 besitzt ein zur Achse des Systemes konzentrisches Durchgangsloch 315, welches von dem konvergierenden, aus der Strahlformungs- und Fokussieroptik kommenden Laserstrahl 316 durchtreten wird. In der Durchgangsöffnung 315 befindet sich ein Wärmeschutzglas 317, welches für das Laserlicht 316 transparent, für die von dem Werkstück ausgehende Wärmestrahlung 318 dagegen undurchlässig ist. Da das Wärmeschutzglas 317 selbst schlecht wärmeleitend ist, muß es bei höherer Belastung zur Kühlung ein- oder beidseitig angeblasen werden.

Auch der Aluminiumblock 312 besitzt eine Durchgangsöffnung 319, deren Radius entsprechend der Konvergenz des Laserstrahlbündels 316 etwas größer als der Durchmesser der Öffnung 315 des Kupferbleches 311 ist.

Bei der obigen Beschreibung wurde davon ausgegangen, daß es sich bei den Einzelemittern um einzelne Laserdioden handelt. Es ist jedoch auch möglich, als Einzelemitter kohärent gekoppelte Einzellaserdioden oder Laserdioden-Arrays einzusetzen, so daß die Leistungsdichte im Fokus entsprechend gesteigert werden kann.

Bei einem weiteren, in der Zeichnung nicht dargestellten Ausführungsbeispiel der Vorrichtung wird in der Abbildungsoptik ein vergrößertes Zwischenbild erzeugt. Diese Ausführungsform eignet sich besonders dafür, durch Zu- oder Abschalten von einzelnen oder Gruppen von Einzelemittern entsprechende Figuren im Brennpunkt zu bewirken. So können durch die Erzeugung von punktförmigen matrixförmigen Zwischenbildern, die durch Zu- oder Abschalten entsprechender Einzelemitter erzeugt werden, Schrift- oder andere Zeichen zum Gravieren der Werkstückoberfläche erzeugt werden. Es können auch matrixförmige Foki in der Form des Pin-Outs von integrierten Schaltkreisen, insbesondere von SMD-Bauteilen, erzeugt werden, um diese simultan auf eine vorbereitete Leiterplatte zu löten. Hierdurch lassen sich besonders kurze Arbeitszeiten im Mikrosekundenbereich erreichen.

Zu Visualisierung der Lage des Brennpunktes können zwei im sichtbaren Wellenlängenbereich strahlende Laserdioden verwendet werden, die auf demselben Kreis wie die Einzelemitter liegen und deren Strahlenbündel sich im Fokusbereich kreuzen.

Statt eines Polygonspiegels mit außen liegenden reflektierenden Flächen kann auch ein solcher mit innen liegenden Spiegelflächen verwendet werden.

## Patentansprüche

1. Verfahren zur Überlagerung von Strahlenbündeln,
die von einer Vielzahl von Einzelstrahlungsquellen ausgehen und mit Hilfe einer Strahlformungs- und Fokussieroptik zusammengeführt werden, wobei die Einzelstrahlungsquellen auf mindestens einer die optische Achse der Strahlformungs- und Fokussieroptik umgebenden Kurve angeordnet sind,
**dadurch gekennzeichnet, daß**
die Einzelstrahlungsquellen (201) so um die optische Achse (202) der Strahlformungs- und Fokussieroptik herum angeordnet werden, daß die Anordnung zu keiner die optische Achse (202) enthaltenden Ebene spiegelsymmetrisch ist.

2. Verfahren nach Anspruch 1, **dadurch gekennzeichnet,**
**daß** die Anordnung eine in Bezug auf die optische Achse (202) der Strahlformungs- und Fokussieroptik nzählige Symmetrie aufweist, wobei n eine ungerade, ganze Zahl größer als 1 ist.

3. Vorrichtung zur Überlagerung von Strahlenbündeln,
die von einer Vielzahl von Einzelstrahlungsquellen ausgehen, mit einer Strahlformungs- und Fokussieroptik, welche die Strahlenbündel zu einem Überlagerungspunkt zusammenführt, wobei die Einzelstrahlungsquellen auf mindestens einer die optische Achse der Strahlformungs- und Fokussieroptik umgebenden Kurve angeordnet sind,
**dadurch gekennzeichnet, daß** die Einzelstrahlungsquellen (201) so um die optische Achse (202) der Strahlformungs- und Fokussieroptik herum angeordnet sind, daß die Anordnung zu keiner die optische Achse (202) enthaltenden Ebene spiegelsymmetrisch ist.

4. Vorrichtung nach Anspruch 3, **dadurch gekennzeichnet, daß** die Anordnung in Bezug auf die optische Achse (202) der Strahlformungs- und Fokussieroptik eine n-zählige Symmetrie aufweist, wobei n eine ungerade, ganze Zahl größer als 1 ist.
